# EUROPEAN PATENT APPLICATION

(11) **EP 2 020 832 A2**
(43) Date of publication of application: **04.02.2009**
(21) Application number: 08013439.8
(22) Date of filing: 25.07.2008
(51) Int. Cl.: H05K 1/02

(54) **Product optimization process for embedded passives**

(30) Priority: 31.07.2007 US 830940
(71) Applicant: Harris Corporation, Melbourne FL 32919 (US)
(72) Inventor: Bendix, Lendon L., Melbourne FL 32940 (US)
(74) Representative: Schmidt, Steffen

(57) **Abstract**

A method is provided for manufacturing a multi-layer circuit board having embedded passive components. The method includes selectively removing portions of at least one layer of the multi-layer circuit board (300) to form a two dimensional array of test points (304) defining a grid extending across a surface of the multi-layer circuit board in those areas on which a circuit is to be formed. The method also includes measuring at each of the test points at least one electrical parameter which is useful for defining a characteristic of the multi-layer circuit board. The method further includes selectively modifying the geometry of at least one embedded passive component to be formed on the multi-layer circuit board based on an analysis of a result obtained in the measuring step.

## Description

The inventive arrangements relate to circuit boards. More particularly, the present invention relates to a method for manufacturing multi-layer circuit boards having interconnecting substrates and passive components embedded directly into the interconnecting substrates.

There is a growing demand to design and manufacture smaller circuit boards having increased functionality. As such, a new circuit board technology has emerged. This circuit board technology deals with embedding passive components directly into circuit boards. This embedding is achieved by placing one or more passive components between two (2) interconnecting substrates of a circuit board. The passive components include, but are not limited to, capacitors, resistors, and inductors. It should be noted that there are many benefits to embedding passive components into a circuit board. These benefits include, but are not limited to, decreased board area requirements, decreased wiring density requirements, decreased assembly costs, and increased circuit performance due to shorter signal paths.

One conventional technique for manufacturing embedded passive components in circuit boards uses a certain type of multi-layer board. The board typically comprises a dielectric base layer, a passive material layer disposed on top of the dielectric base layer, and a conductive metal layer disposed on top of the passive material layer. Circuit traces and embedded components are formed by selectively etching the conductive metal layer and the passive material layer.

Manufacturing of circuit boards with embedded components also involves a design step for designing one or more passive components. For example, this can include selecting the dimensions and shape of each embedded passive component. This design step requires knowledge of one or more nominal published values which represent one or more electrical characteristics of the board on which the passive components are formed. The nominal published value is typically provided by a board manufacturer.

For example, one such nominal published value is sheet resistance. The sheet resistance is a measure of resistance of the passive material layer. Sheet resistance is measured in ohms/square, and is primarily used for thin layers where the thickness of the layer is negligible compared to its other dimensions. For example, a board material as provided by a manufacturer might have a published sheet resistance of five hundred (500) or one thousand (1000) ohms/sq. Other nominal published values are also used to characterize passive board materials. For example, board materials designed especially for forming embedded capacitors can include published values which define a sheet capacitance density in terms of nanofarads per centimeter squared (nF/cm²).

For purposes of designing embedded passive components, the published sheet resistance and capacitance values are useful. However, the tolerances involved in such published values substantially limit the precision of the components that can be formed. The actual values of the passive materials forming the circuit boards can and do vary significantly across the board surface compared to published values. In fact, the actual value at specific locations on the board can typically vary from the nominal published values by plus or minus ten percent (+/- 10%). These broad tolerances can result in rather large variations in the value of the embedded passive components formed on the board, particularly when the material variations are combined with other manufacturing tolerance errors. For example, the design and etching process can also introduce errors.

In order to reduce such errors, a mechanical or laser trimming process is commonly used after the etching process is completed. This analysis can include the use of a multi-meter or other suitable device configured to measure resistance, capacitance, and/or inductance of each embedded device. If it is determined that the passive component does not have the desired characteristics, then an iterative mechanical or laser trimming process is performed to correct the deficiency in the passive component material. It should be noted that the mechanical or laser trimming process can only be performed when the measured resistance value, capacitance value, or inductance value is greater than a desired value. Adding passive component material to the etched board is not an option. As such, the board is discarded when the measured resistance value, capacitance value, or inductance value is less than a desired value.

Despite the advantages of the above-described manufacturing process, it suffers from certain drawbacks. For example, the manufacturing process is absent of a step for accounting for design limitations of the software used to create the boards. The manufacturing process is also absent of a step to account for measurement errors due to equipment shortcomings. This manufacturing process also results in low circuit performance and approximately a forty percent (40%) yield on circuit board fabrication. This manufacturing process does not address frequency response or variation of passive component materials across a surface of a board. In this regard, it should be noted that the mechanical or laser trimming process attempts to correct passive component material deficiencies instead of adapting to passive component material variability. Further, the mechanical or laser trimming process is labor intensive, costly, and time consuming.

In view of the forgoing, there is a need for a method of manufacturing a multi-layer circuit board having embedded passive components which is less labor intensive, costly, and time consuming as compared to conventional manufacturing processes. There is also a need for a method of manufacturing a multi-layer circuit board having embedded passive components that provides relatively high circuit performance and yield on circuit board fabrication. There is further a need for a method of manufacturing a multi-layer circuit board having embedded passive components that is configured to adapt to passive component material variability.

The invention concerns a method for manufacturing a multi-layer circuit board having embedded passive components. The method begins by selectively removing portions of at least one layer of a multi-layer circuit board to form a two dimensional array of test points. The test points are arranged to define a grid extending across a surface of the multi-layer circuit board in those areas on which a circuit is to be formed. For example, the two dimensional array of test points can be a linear two-dimensional array forming an x, y grid. However, the test points are advantageously excluded from selected areas of the multi-layer circuit board panel where an embedded passive component or circuit trace will be placed in a subsequent processing step.

The method continues by measuring at each of the test points at least one electrical parameter which is useful for defining a characteristic of the multi-layer circuit board. For example, a resistance, an impedance, or a capacitance parameter can be measured at each test point. The data from these measurements can be stored in a data file for use in a subsequent analysis step. The analysis is advantageously selected to include a neural analysis. In this regard, the neural analysis process can include determining a system identification for the multi-layer circuit board.

The method also includes selectively modifying the geometry of at least one embedded passive component to be formed on the multi-layer circuit board. The modification of the geometry is advantageously based on an analysis of a result obtained in the measuring step. At least one embedded passive component is formed on the multi-layer circuit board based on or using the geometry which has been modified.

The multi-layer circuit board can include a conductive metal layer, a dielectric layer, and a passive material layer disposed between the conductive metal layer and a dielectric layer. Each test point can be formed by removing a portion of the conductive metal layer to isolate a center contact from a remaining portion of the conductive metal layer. For example, the portion of the conductive metal layer which is removed can have an annular profile which is coaxial with the center contact.

According to one aspect of the invention, a pattern formed by the two-dimensional array of test points is modified at selected locations to align a location of at least one test point with a location of the multi-layer circuit board panel where a via will be placed. In that case, a second measuring step can be performed at each of the test points aligned with the vias to determine the at least one electrical parameter which is useful for defining the characteristic of the multi-layer circuit board. The second measuring step can be performed after at least a portion of a circuit has been formed on the multi-layer circuit board panel. If such a second measuring step is used in the process, the analysis step can be repeated using measurement data acquired in the second measuring step.

The measuring and the analyzing steps described herein can be repeated for each one of a plurality of the multi-layer circuit boards to be manufactured with a particular embedded circuit design. The neural analysis can continue to learn with each board that is measured and analyzed. This iterative process continually improves an accuracy of the analysis with each repetition of the analyzing step.

Embodiments will be described with reference to the following drawing figures, in which like numerals represent like items throughout the figures, and in which:
FIGS. 1A-1G show a conventional process for manufacturing embedded passive components.
FIG. 2 is a flowchart which is useful for understanding a method for manufacturing embedded passive components.
FIG. 3 is a drawing which shows a top view of a circuit board on which a test pattern has been formed.
FIG. 4 is an enlarged view of a portion of FIG. 3 showing individual test points.
FIG. 5 shows a cross-sectional view of the individual test points in FIG. 4.
FIGS. 6A and 6B show alternative embodiments of the individual test points in FIG. 4.
FIG. 7 is a top view of the circuit board in FIG. 3 after embedded passive components have been formed.

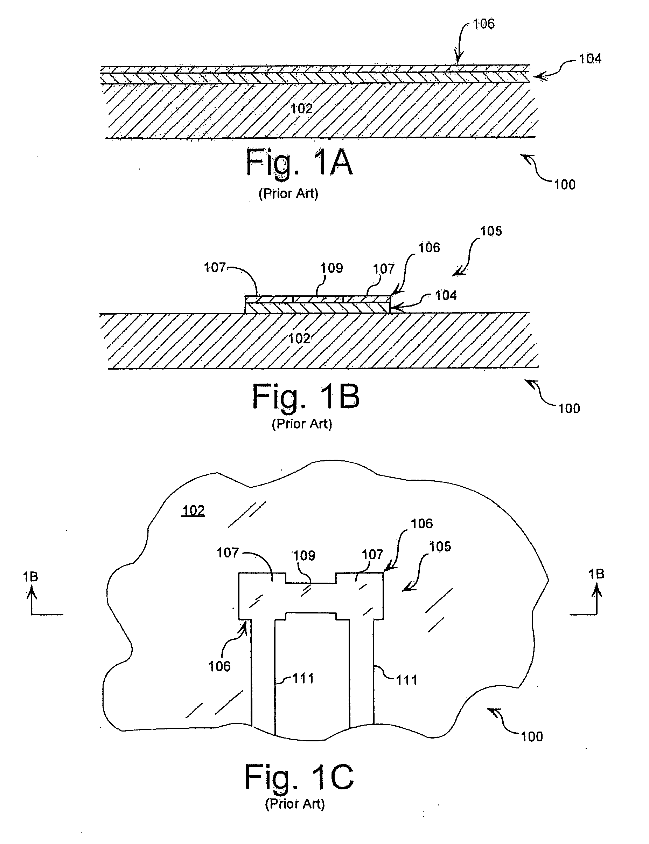

In order to assist the reader in understanding the inventive arrangements, a conventional process used to form embedded passive components in circuit boards will be described. This conventional process is illustrated in FIG. 1A-1G. The process begins by selecting a circuit board panel ("a board") 100 as shown in FIG. 1A. The board 100 has a dielectric layer 102, a passive component layer 104, and a conductive metal layer 106. The dielectric layer can be comprised of a woven glass material, a non-woven glass material, or any other dielectric material known in the art. The passive component layer 104 is typically comprised of a passive component material suitable for fabricating resistors ("resistor material") or for fabricating capacitors ("a capacitor material"). The resistor material can include a metal thin film on a copper foil, a polymer thick film, a ceramic thick film, or the like. The capacitor material can include, but is not limited to, a polyimide, a proprietary dielectric, an epoxy, a ceramic thick film, or a photopolymer. Inductors can be formed on the passive component layer 104 by forming traces in the conductive metal layer 106.

In a conventional etching process used to form a passive component layer of a multi-layer circuit board, it is common to proceed in two separate steps. In the first step, the conductive metal layer 106 and the passive component material 104 are etched away to define circuit traces and other metal structures on the surface of the board. In this first step, the conductive metal layer 106 is not removed from portions of the board where the passive component 105 will be defined. The results of this first step are illustrated in FIG. 1B and 1C in which circuit traces 111 and electrical contacts 107 for a passive component are defined. Note that in FIG. 1B and 1C, the portion 109 of the conductive metal layer 106 has not been removed from the portion 109. Removal of portion 109 of conductive metal layer 106 is typically performed in a second etching step to complete the formation of the passive component 105.

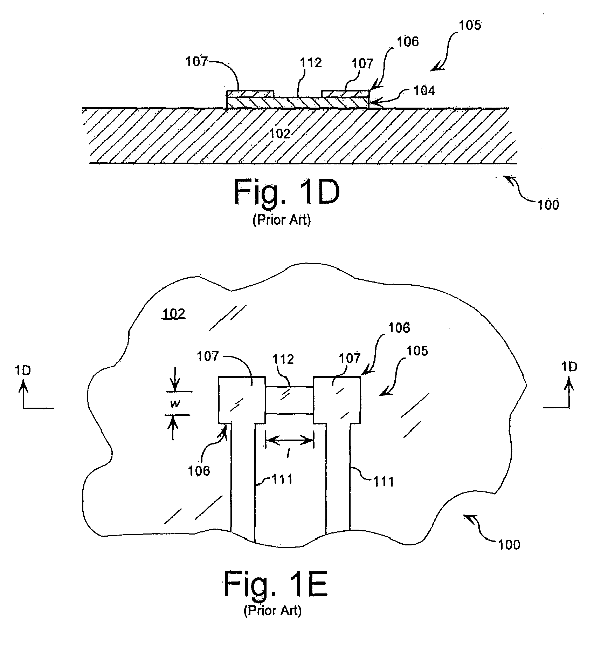

The results of the second etching step are shown in FIG. 1D and 1E. The portion 109 of the conductive metal layer has been removed in FIG. 1D and 1E to define a body portion 112 of the passive component material 104. The geometry (i.e., shape, length and width) of body portion 112 will define the component value of the passive component 105. It will be appreciated that the size and shape of the exposed passive component material can affect the resistance, capacitance or inductance of the passive component.

For example, in FIG. 1D and 1E, the passive component 105 is a resistor. The resistor includes electrical contacts 107 formed from conductive metal layer 106 and a body portion 112. Accordingly, the material forming the passive component layer 104 would be a resistive type material. Referring to FIG. 1E, it should be understood that the length I and the width w of the body portion 112 will affect the resistance value of the resistor thus formed. The resistance value will also be affected by the type of material used to form the passive component layer 104. For a given length and width of the body portion 112, materials having a higher sheet resistance will produce correspondingly larger resistance values.

Due to tolerances and variations in the design, passive material layer, and the etching process, the actual values of one or more passive components 105 formed with the foregoing process are often not the precise values which were desired by a designer. In order to correct such deficiencies, the geometry of the embedded passive component can be modified in a subsequent step. This trimming process is generally necessary to achieve a sufficient level of precision with regard to the values of the embedded passive components. The trimming process can be performed with a laser. However, the laser trimming process is inefficient, time consuming, and expensive.

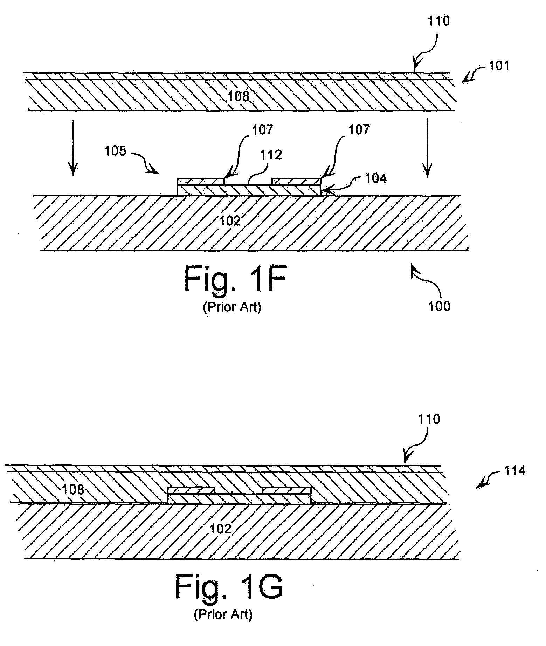

Referring now to FIG. 1F, the conventional manufacturing process can continue with a second board 101 being disposed on top of the board 100 after the etching process is completed and the passive component(s) 105 has been formed. A filler material (not shown) can also be inserted between the board 100 and second board 101. The second board 101 is typically formed from a layer of dielectric material 108 and a layer of conductive metal material 110. For example, the conductive metal material 110 is often formed of copper. The second board 101 is joined to the first board 100 to form the board 114 as shown in FIG. 1G. In this regard, it should be noted that the thickness of layers 104, 106 is shown greatly enlarged in FIG. 1A-1G for greater clarity. Further it should be understood that the conductive metal material 110 can be further etched in a subsequent manufacturing step to form circuit traces, and any other required structure.

It will be appreciated by those skilled in the art that one or more embedded passive components 105 can have through vias (not shown) to connect the embedded passive component 105 to conductive metal material 110 of the multi-layer circuit board 101 and/or hidden vias to connect the passive component 105 to another layer of the multi-layer circuit board (not shown). In this regard, it should be appreciated that the circuit board 114 may include two or more embedded passive component arranged in a series or parallel configuration.

In order to overcome the limitations of the conventional processes described above, an embodiment of the present invention will now be described. The basic fabrication techniques utilized with the inventive process are similar to those described above in relation to FIG. 1A-1G. However, the inventive arrangements substantially reduce or eliminate the need to perform the time consuming and expensive trimming process.

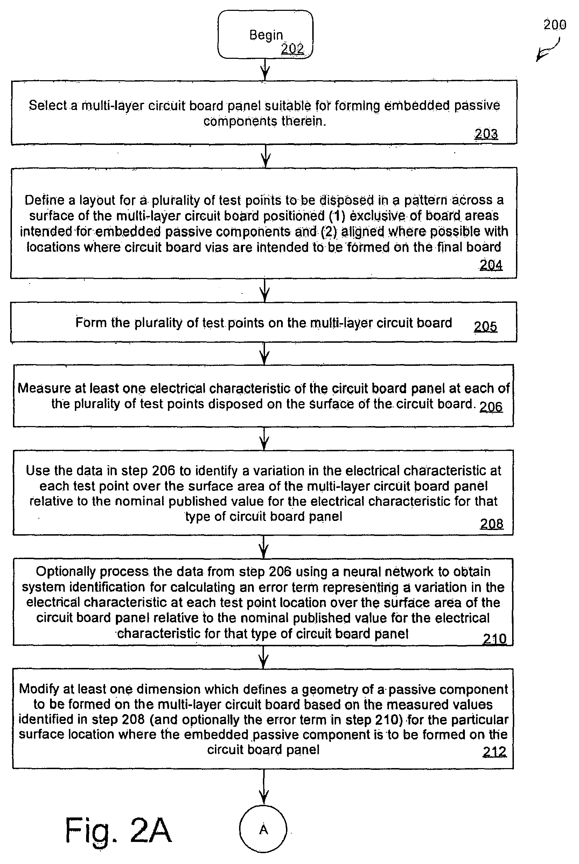

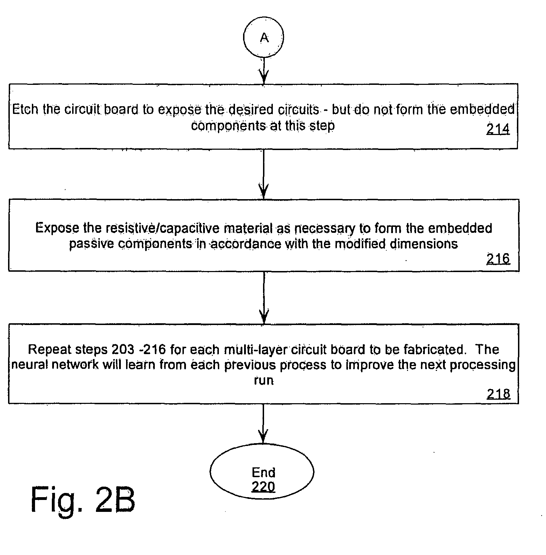

Referring now to FIG. 2, a process 200 can begin at step 202 and continue to step 203. In step 203, a multi-layer circuit board panel is selected which is suitable for forming an embedded passive component therein. Such boards are well known in the art and therefore shall not be described in detail herein. However, the multi-layer circuit board panel can have a structure similar to the board 100 described in FIG. 1.

After a multi-layer circuit board panel has been selected in step 203, the process continues on to step 204. In step 204, a layout is defined for a plurality of test points to be disposed in a pattern across a surface of the multi-layer circuit board. The test points are described in more detail below. The term layout is generally used to refer to an arrangement or placement of the test points. The layout is conventionally created as a computer file or computer generated mask work using a computer aided design tool. The layout is conventionally used in a subsequent processing step to define which portions of a circuit board will be etched. The terms layout and mask are well known to those familiar with the process of designing and etching circuit boards.

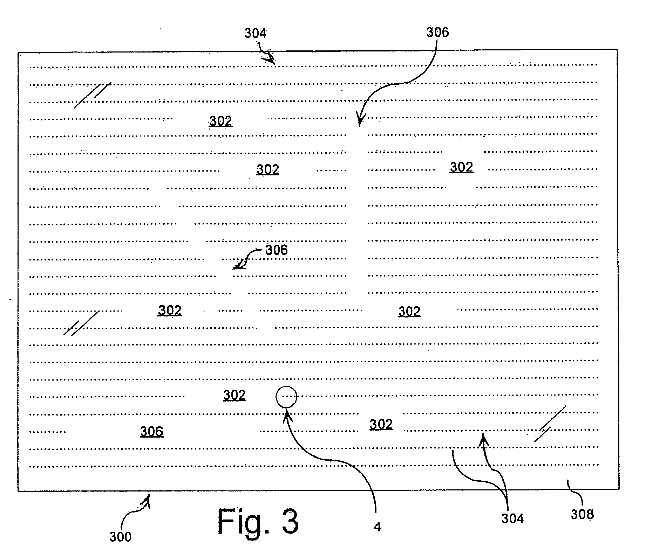

Referring now to FIG. 3, the layout for the test points 304 is preferably defined such that the test points 304 are positioned on the multi-layer circuit board panel 300 (1) exclusive of board areas 302 which are reserved for embedded passive components and (2) aligned with possible locations where circuit board vias are intended to be formed on the multi-layer circuit board panel 300. According to a preferred embodiment, the layout for the test points is generally arranged to form a grid-like pattern. In step 205, the plurality of test points 304 defined by the layout are formed on the surface of the multi-layer circuit board panel 300. The test points can be formed on the multi-layer circuit board panel 300 using any known technique. For example, a conventional etching technique can be used for this purpose.

Referring to FIG. 3, it can be observed that the test points 304 are generally aligned in a grid pattern across the surface of the multi-layer circuit board panel 300. Test points 304 are also formed so that they are aligned with locations on the circuit board where vias are intended to be provided in the final circuit. According to one embodiment, locations of test points on the grid pattern can be shifted in position somewhat relative to the grid pattern in order to achieve such alignment. Alternatively, changes to the grid pattern of test points can be avoided and test points can simply be added at the locations on the circuit board where vias are intended to be provided. Locating the test points at via locations can be particularly useful for evaluating the electrical characteristics of the circuit board at the local area around where a via between circuit board layers will eventually be formed.

According to a preferred embodiment, the grid pattern described above can include test points locations generally aligned along a plurality of transversely oriented grid lines. For example the transversely oriented grid lines can advantageously be oriented so that they are orthogonal to each other as shown. However, the invention is not limited to a particular grid pattern. Instead, any other arrangement of test points at known locations on the board can be used. The exact number or pattern selected for the test points 304 is not critical. However, a larger number of test points is helpful to more completely identify the electrical characteristics of the multi-layer circuit board 300 as described below.

As shown in FIG. 3, the test points 304 are advantageously omitted from those areas 302, 306 of the circuit board where embedded circuit traces and embedded passive components are intended to be formed. The purpose of omitting the test points from these areas 302, 306 is to preserve such areas so that circuit traces and passive components can be formed in these areas at a later point in the process.

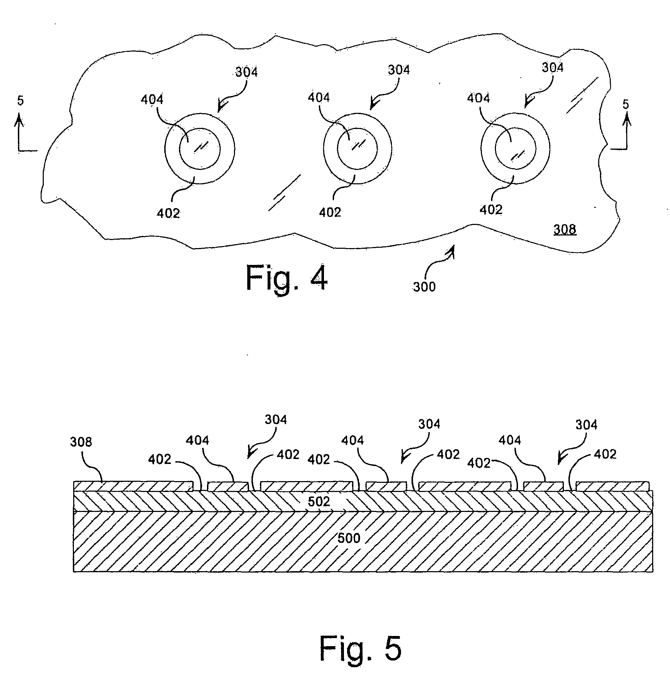

Referring now to FIG. 4, there is shown an enlarged view of the test points 304. As can be observed in FIG. 4, each test point 304 can be comprised of an annular ring area 402 where a portion of a conductive metal layer 308 has been etched away or otherwise removed to expose a passive material layer 310. A cross-sectional view showing these features is provided in FIG. 5 which shows dielectric layer 500, passive component layer 502 and conductive metal layer 308. Each test point 304 includes a center contact 404 formed from conductive metal layer 308. In this regard, it should be understood that each test point 304 can be thought of as a passive electrical component formed on the board. The actual value of the passive component defined by each such test point can be measured. For example, those skilled in the art will appreciate that a test probe can be electrically coupled to each center contact 404. For purposes of resistance and/or impedance measurements, a second test probe can be connected to the surface of conductive metal layer 308. In this way, a resistance and/or impedance value of the passive component layer 502 can be evaluated at each test point 304.

The measured values obtained at each test point 304 can be used to calculate a sheet resistance for that local area of the multi-layer circuit board 300 where the test point 304 is located. However, in addition to merely providing information regarding the board material, it is important to recognize that the test point measurement results will be affected by tolerance errors associated with the layout, masking, and etching process for the circuit board. As shall be explained below in further detail, the combination of such board variations and processing tolerance errors can be statistically analyzed using conventional techniques. Information gained from such statistical analysis can thereafter be used to modify the geometry of passive embedded components formed on the board so as to compensate for such board variations and processing errors. The information can be used in the subsequent etching steps on the same board and in the fabrication of subsequent boards.

It should be understood that various measurements can be performed at each test point 304. For example, in addition to resistance measurements, a measurement at each test point can include a capacitance measurement. The capacitance can be measured between the center contact 404 and a conductive metal ground plane (not shown) which is disposed below dielectric layer 500 in FIG. 5. The capacitance measurement can be used to characterize a capacitance per unit area for the local area of the multi-layer circuit board 300 surrounding each particular test point 304. A measurement at each test point can also include an inductance measurement. The following discussion in relation to paragraph [0045] is sufficient for understanding such inductance measurements and the type of test points used for said measurements.

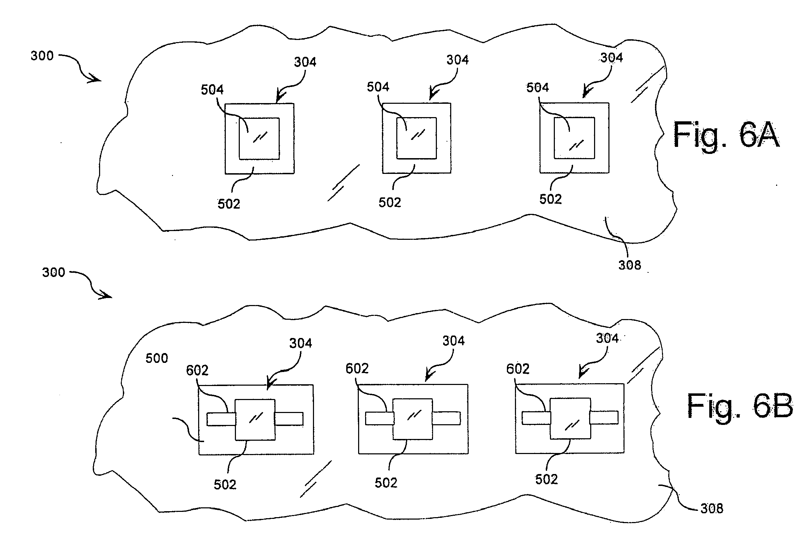

Referring now to FIGS. 6A and 6B, there are shown alternative embodiments of the test points described above in relation to FIGS. 4 and 5. In FIG. 6A, the test points are formed so that an area of the conductive metal layer 308 which has been removed has a square profile instead of a ring profile. The test points of FIG. 6A can be advantageously used for characterizing a capacitive material. In such a scenario, a capacitive meter can be connected to a contact provided in the middle of the test point and to a ground plane existing below the contact. In FIG. 6B, the test points are formed by removing a portion of the conductive metal layer 308 and a portion of the passive component layer 502. As shown in FIG. 6B, each test point is comprised of two (2) copper pads, an area of exposed passive component layer 502, and an area of exposed dielectric layer 500. The test points of FIG. 6B can be advantageously used for determining a sheet resistance. In some instances, test points as shown in FIGS. 6A and 6B can be more convenient to use instead of the annular ring structures described in relation to FIGS. 4 and 5. Still, it should be understood that the invention is not limited to the particular test point geometry shown. Other test point geometries can also be used without limitation.

According to an embodiment of the invention, a location of each test point 304 can be defined by means of an (x, y) coordinate. For example, the first three test points 304 in the first row on multi-layer circuit board panel 300 can be respectively identified by (x, y) coordinates (1, 1), (2, 1), and (3, 1). In this way, data acquired at each test point can be identified with reference to the x, y coordinates of the particular test point where the data was measured.

Referring once again to FIG. 2, the process can continue in step 206. In step 206, one or more electrical characteristics of the multi-layer circuit board panel 300 are measured at each test point 304. For example, the electrical characteristic that is measured at each test point 304 can include a resistance value at DC and a capacitance value. Other measurements are also possible as will be understood by those skilled in the art. For example, if a circuit to be formed on the multi-layer circuit board is intended to be operated at a frequency above zero (0) Hertz, then it can be useful to also measure an impedance value at each test point 304. Impedance can be measured by providing a test probe electrically coupled to each center contact 404. For purposes of impedance measurements, a second test probe can be connected to the surface of conductive metal layer 308.

In those instances where impedance is measured, the impedance value will be a complex value having a resistive component and a reactive component. As will be appreciated by those skilled in the art, the impedance measured at each test point 304 will vary as a function of frequency. Accordingly, it is preferred that the impedance measurement be performed at each test point 304 at least at an intended operating frequency of the completed multi-layer circuit board panel 300. Alternatively, the impedance measurements can be performed over a range of frequencies. The range of frequencies can be selected to include frequencies at which a circuit to be formed on multi-layer circuit board panel 300 will be operated. For example, if it is known that a circuit to be formed on multi-layer circuit board panel 300 will be operated at five hundred (500) MHz, then the range of test frequencies should include five hundred (500) MHz.

The measurements at each test point 304 can be performed using a manually operated measuring device or an automated measuring system. Such automated electronic devices include, but are not limited to, a probe type test system and a "bed-of-nails" type test system. Each of these types of test systems is well known to persons skilled in the art, and therefore will not be described in great detail herein. According to an embodiment of the invention, the probe type test system is a robotically controlled test probe that is calibrated to provide resistance measurement with a precision which is equal to or better than one one-thousandths of an ohm (0.001 Ω). Still, the invention is not limited in this regard.

For each test point 304 having a given geometry and formed on a particular type of board material, there will be an expected measurement result. This expected measurement result can easily be calculated based on the published electrical characteristics of the board and the geometry which has been selected for the test point. However, there are several factors which will cause the actual measurements performed at the test point 304 to deviate from the expected measurement result. These factors include without limitation (1) variations in the electrical characteristics which occur across the surface of the board, (2) tolerance errors in the layout process, (3) tolerance errors in the masking process, (4) tolerance errors in the etching process, and (5) tolerance errors in the measurement equipment. As used herein, the term tolerance errors should be understood as referring to minor dimensional variations in the geometry of the passive component that are beyond the ability of a designer to control. Although such errors cannot be controlled, they can be modeled using known techniques for statistical analysis. The process of modeling such errors begins with the acquisition of measurement data at each test point 304 and comparing it to the expected measurement value.

Referring now to step 208, the process can include using the data from step 206 to identify variations in expected measurement values relative to the actual measurement values obtained at locations of different test points 304. A determination of such expected measurement values can be made based on the geometry of the test points 304 and a nominal published value for the board electrical characteristics provided by a manufacturer. For example, at DC, this determination can involve determining a difference between a measured value and an expected value that is based on published manufacturer data for a particular multi-layer circuit board panel 300. The determination in step 208 can be made with regard to variations in sheet resistance or resistivity, capacitance, inductance or any other value.

At higher frequencies, this determination of variations in expected measurement values relative to actual measurement values can include a comparison of the measured complex impedance value Z at a test point to a pure resistance value expected at such test point based on a published sheet resistance specification for a particular type board material. In this regard, it will be understood that the complex impedance value Z = R + jX can include a real component (R or resistance) and a reactive component X, which can be positive or negative depending on whether the reactance is capacitive or inductive. As will be appreciated by those skilled in the art, the reactive value X can be determined by subtracting from the measured complex impedance value the actual resistance value R for a particular test point as measured at DC. The result will be the reactive component of the impedance X at a particular frequency.

Referring again to FIG. 2, the process can continue at optional step 210. In step 210, the data collected in step 206 and/or 208 can be processed using a neural network. This processing step will be discussed in more detail below. In general, however, the phrase "neural network" as used herein refers to an adaptive, linear or non-linear statistical data modeling tool that models complex relationships between inputs and outputs to find patterns in data. Neural networks are well known in the art and therefore will not be described in detail. In general, however, the neural network processing step described herein will use the data from step 206 and/or 208 to provide an output which is an improved estimation of the errors associated with the design and fabrication of the embedded passive components on the board measured in step 206. For example, the neural analysis can use a linear regression analysis and/or a stochastic processing analysis to compute a polynomial system identification for the board. The system identification for the board will model the variations in the actual characteristics of passive components formed on the board relative to the expected values of such passive components. Such a system identification can be useful for adjusting the design geometry for embedded passive components provided in a board layout to obtain actual fabricated embedded passive components that more accurately achieve desired component electrical values.

As used herein, the term linear regression analysis generally refers to any one of a variety of well known statistical methods which are useful for examining the relation of a dependent variable (e.g. a resistivity value, capacitance value or inductance value) to specified independent variables (such as a location on a board surface). The mathematical model which defines the relation between the dependent variable and the independent variable is referred to as a regression equation. A least mean squares analysis is one such well known method for linear regression that can be used for this purpose.

The system identification can be a transfer function, equation or a matrix that provides a mathematical model representing a particular electrical characteristic of the circuit board 300. For example, the system identification can be a model of the resistively values (or variations in such values) occurring over the surface of the multi-layer circuit board 300. According to one embodiment of the invention, the system identification can model resistivity, capacitance, inductance or impedance. Still, the invention is not limited in this regard and any other electrical characteristic of the multi-layer circuit board can also be modeled. The system identification can be used to determine error terms associated with an x, y coordinate location of each test point 304. The error term for each test point 304 can represent a variation in the measured electrical characteristic at such test points relative to a nominal published value for such electrical characteristic. In this regard, the neural network processing can help to eliminate measurement errors associated with step 206 and can provide a more complete and accurate model for the entire multi-layer circuit board 300, and the processes used to fabricate such board.

The process continues in step 212. In this step, at least one dimension of at least one passive network component to be formed on the multi-layer circuit board panel 300 is modified based on the board variations and tolerance errors which are statistically identified in steps 206, 208 and 210. For example, referring to FIG. 1C, a design length *1* or design width w of a component in a computer aided design tool can be adjusted to be wider or narrower. The actual adjustment will depend upon the statistical errors associated with variations in the electrical characteristics of the multi-layer circuit board panel 300 at the location where the passive component will be formed, and on the statistical modeling of tolerance errors associated with the fabrication process. In this way, the design of the passive component to be formed on the board can be modified to compensate for such errors. Step 212 can be performed for each passive component which is intended to be formed on the multi-layer circuit board panel 300. These modified dimension values can be incorporated into a layout for the multi-layer circuit board panel 300 using a computer aided design program. For example, the polynomial system identification and/or the error values computed in step 210 can be used by the computer aided design tool to determine the modified dimensions and such modified dimensions can be incorporated into a modified layout of the embedded passive components. Once the layout has been modified in this way, the process continues on to step 214.

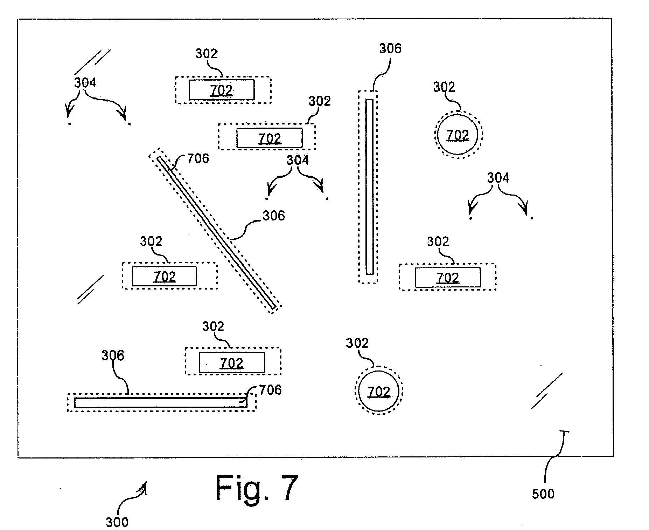

In step 214, a circuit can be etched or otherwise formed on the multi-layer circuit board panel 300. Referring to FIG. 7, this step involves creating conductive traces 706 and possibly defining other circuit structures, but does not include final exposure of the resistive or capacitive material necessary to complete the formation of the embedded passive components 702, such as resistors, capacitors or inductors.

The circuit forming process in step 214 can proceed in accordance with a conventional process suitable for the particular type of multi-layer circuit board panel 300. For example, a first step in a conventional etching process can be used to form the circuit on the board. As part of this etching process, most of the test points 304 can also be removed or etched away. However, those test points 304 which are aligned with vias can be retained on the surface of the board.

In FIG. 7, it can be observed that most of the test points 304 are no longer present after completion of step 214. In this regard, it should be understood that once the electrical characteristics of the circuit board have been measured in step 206, the test points 304 can be removed as part of the etching process that is used to form the embedded circuit traces 706 and embedded passive components 702. Still, it should be noted in FIG. 7 that some of the test points 304 are allowed to remain on the multi-layer circuit board panel 300. These test points 304 are ones which are aligned with vias that are intended to be formed on the multi-layer circuit board panel 300 in a subsequent processing step. These test points 304 will become a part of via pads. It should be noted that the objective is to provide a test point at the exact location of future via sites. Characterization data of the resistive material is obtained at each of the test points 304. Once the characterization is completed, the test points 304 will be drilled for via holes. Thereafter, barrels of vias will be inserted such that the test points 304 become via pads.

In step 216, the second step in a conventional etching process can include using the modified layout defined in step 212 to finally expose the resistive/capacitive material (passive material layer 502) as necessary to precisely form the embedded passive components in accordance with the modified dimensions. A conventional etching process can be used for exposing the passive material layer 502.

Referring again to FIG. 7, it can be observed that the embedded circuit traces 706 and embedded passive components 702 have been formed in the areas 302, 306 of the multi-layer circuit board panel 300. As noted above, these areas 302, 306 were intentionally maintained free of test points 304 so as not to interfere with the formation of the passive components and circuit traces 702, 706 in step 214 and 216.

In step 218, the processing associated with steps 203-216 can be repeated for each additional circuit board to be fabricated. Each time these steps are repeated, the neural network will continue to learn based on the measured data so as to improve the next processing run. In step 220, the process can end.

Those skilled in the art will appreciated that the embedded passive component design for multi-layer circuit board panel 300 can be created using a computer aided design (CAD) tool. Computer aided design (CAD) tools are well known to persons skilled in the art, and therefore will not be described in great detail herein. However, it should be appreciated that any such computer aided design (CAD) tool can be used without limitation. The design process can involve storing information defining the passive component design in a data file.

A computer aided design tool can also be configured to read the stored data defining the passive component design. The tool can be configured to add the embedded passive component to a component library so that the passive component can be added to a multi-layer circuit board layout. As used herein, the term layout refers to any representation that is useful for defining an arrangement or placement of of components 702 and traces 706 which will be formed on the multi-layer circuit board panel 300. The term layout is also used to refer to an arrangement or placement of the test points 304 as described above. As should be understood, defining a shape of a multi-layer circuit board and creating a component layout for a multi-layer circuit board panel 300 is well known in the art. The design process can further include defining buried and through via locations on the multi-layer circuit board. Buried and through vias are well known to persons skilled in the art, and therefore will not be described in great detail herein.

According to a preferred embodiment, the multi-layer circuit board layout should be arranged to allow for a change in a geometry of the embedded passive component due to a neural analysis. This geometry change can include modifying a width and/or a length of the embedded passive component. Thus, sufficient area is preferably provided surrounding the location of each passive component so that such geometry changes do not cause the need for other layout changes. In this regard, a suitable buffer zone can be defined around each passive component included in the layout so as to accommodate such geometry changes.

As noted above, a neural analysis as described herein is an adaptive, linear/non-linear statistical data modeling process. The neural analysis is used herein to model complex relationships between measured resistance or capacitance values and outputs of the neural analysis which are used to adjust embedded passive component dimensions. The neural analysis is also used to identify patterns in measured resistance or capacitance values and outputs of the neural analysis. As will be appreciated by those skilled in the art, a variety of different techniques and methods can be used for implementing such a neural analysis as described herein without limitation. Any suitable neural network analysis can be used without limitation provided that it makes use of the measured data described herein to more precisely characterize or model the electrical characteristics of the multi-layer circuit board panel 300.

Likewise, it should be understood that the invention described herein can be implemented by alternative means other than a neural network. Although less desirable, more conventional computer processing techniques can be used to characterize the electrical characteristics of a multi-layer circuit board panel 300 based on measured data. In this regard, any suitable algorithm can be used to the extent that it uses the measured data regarding the board electrical characteristics to create a system identification for such board.

## Claims

1. A method for manufacturing a multi-layer circuit board having embedded passive components, comprising:
selectively removing portions of at least one layer of a multi-layer circuit board to form a two dimensional array of test points defining a grid extending across a surface of said multi-layer circuit board in those areas on which a circuit is to be formed;
measuring at each test point of said test points at least one electrical parameter which is useful for defining a characteristic of the multi-layer circuit board;
selectively modifying a geometry of at least one embedded passive component to be formed on said multi-layer circuit board based on an analysis of a result obtained in said measuring step.

2. The method according to claim 1, further comprising selecting said at least one layer to comprise a conductive metal layer.

3. The method according to claim 2, further comprising selecting said multi-layer circuit board to include a dielectric layer and a passive material layer disposed between said conductive metal layer and said dielectric layer.

4. The method according to claim 1, further comprising forming said at least one embedded passive component on said multi-layer circuit board using said geometry which has been modified.

5. The method according to claim 1, further comprising selecting said analysis to include a neural analysis.

6. The method according to claim 1, further comprising selecting said electrical parameter from the group comprising a resistance, an impedance, and a capacitance.

7. The method according to claim 1, wherein said two dimensional array of test points is a linear two-dimensional array forming an x, y grid.

8. The method according to claim 1, further comprising modifying a pattern formed by said two-dimensional array at selected locations to align a location of at least one test point with a location of said multi-layer circuit board where a via will be placed.

9. The method according to claim 8, further comprising performing a second measuring step at each test point of said test points aligned with said vias to re-measure a value of said at least one electrical parameter at said test points which is useful for defining said characteristic of said multi-layer circuit board, said second measuring step performed after at least a portion of a circuit has been formed on said multi-layer circuit board.

10. The method according to claim 1, further comprising excluding said test points from selected areas of said multi-layer circuit board where an embedded passive component or circuit trace will be placed in a subsequent processing step.
